# NEW EUROPEAN PATENT SPECIFICATION

(11) **EP 0 969 964 B2**
(45) Date of publication and mention of the opposition decision: **19.01.2011**
(45) Mention of the grant of the patent: 29.09.2004
(21) Application number: 97940808.5
(22) Date of filing: 04.09.1997
(51) Int. Cl.: B32B 17/00, H01L 23/42

(54) **A THERMAL CONTROL DEVICE**
WÄRMEKONTROLL VORRICHTUNG
DISPOSITIF DE CONTROLE THERMIQUE

(43) Date of publication of application: 12.01.2000
(73) Proprietor: Hayes, Claude Q.C., San Diego, CA 92103 (US)
(72) Inventor: Hayes, Claude Q.C., San Diego, CA 92103 (US)
(74) Representative: Evens, Paul Jonathan
(86) International application number: PCT/US1997/015577
(87) International publication number: WO 1999/011455

(56) References cited:
- EP-A- 0 752 808
- DE-A- 2 233 107
- DE-A- 3 006 733
- US-A- 1 879 128
- US-A- 3 871 684
- US-A- 3 973 397
- US-A- 4 001 126
- US-A- 4 446 916
- US-A- 4 585 843
- US-A- 4 600 634
- 'Aluminium Chemicals Science and Technology Handbook', 1990, THE AMERICAN CERAMIC SOCIETY, INC article LARRY L, MUSSELMAN: 'Production,Processes,Proprerties and Applications for Aluminium containing Hydroxides', pages 75 - 92

## Description

The present invention relates to devices comprising endothermic materials and, more particularly, it relates to the provision of certain acids and their salts, certain bases and their salts, and certain organic compounds as endothermic reaction agents for use in such endothermic materials for the control of temperature and heat in cooling systems for electronic components, structures, surfaces and the like, which are sensitive to changes in temperature.

Often, active cooling of such electronic components, particularly delicate TR modules, Impatt diodes, data recorders and the like, is not feasible and even when it is feasible, it requires continuous high energy cooling which taxes other attached engineering systems such as those typical to missiles, aircraft and related combat systems.

Generally, endothermic devices employ phase change material compositions (PCM's). The conventional PCM materials are largely solid or fluidic in nature, for example, being liquids, quasi-liquids, or solids such as a waxes or other meltable compositions. Over time, the conventional PCM's have proven to suffer from many technical problems as well as problems in their use and application. These problems include relatively low latent heat of fusion, the inability to control the shape and form of such fluid PCM materials as well as the evenness of heating and cooling. Other problems are the need to provide a containment housing and the stress placed on the housing, resulting in frequent rupture and spillage of the PCM; the hazard to life and property due to PCM's high heat content and flammability; and lastly, the uneven heating or cooling hysteresis. For these critical reasons and others, PCM's as thermal storage and temperature control mediums have a long history of failure and nonuse in commercial and military applications.

In Applicant's patent, U.S. Patent No. 4,446,916, Applicant has disclosed what he calls a composite fabric endothermic material (CFEM), providing devices especially suitable as heat sinks for aerospace and military use. The patented CFEM provides an improved heat sink that absorbs heat at the melting temperatures of a compound embedded within a fibrous mesh or matrix. The CFEM preferably comprises a phase change material which is held by capillary action and chemical adhesions to the fibers of the matrix. As a result a greatly increased surface area for heat transfer is obtained.

The normal PCM's can spill hot fluids onto a human's skin, resulting in serious third degree burns due to the sticky contact nature of many hot wax and plastic phase change material and the high heat and sticky adherence to skin. Ruptured non-CFEM or liquified wax PCM disks can spill their content and cause flash fires, which spread as the PCM pours out during heating in ovens. Wax-filled disks are prone to fires, which can spread and flow out of stoves; however, CFEM fabric absorbs and contains liquid PCM, making it difficult to ignite.

While the patented CFEM is suitable for use in food and in military applications, the scope of its suitability for other commercial and civilian applications is limited and is particularly not suitable for high temperature application, flight recorders and oven sensors.

In Applicant's U.S. Patent No. 5,709,914, Applicant addresses the need for an improved CFEM for use in many commercial and civilian applications, particularly for food, home and commercial packaging operations. In this application, improved CFEMs capable of being employed in a variety of commercial applications such as in the food industry where a need has arisen for heat retaining or heat insulating containers, packages and thermal storage devices.

The endothermic agents, i.e. heat absorbing agents suggested in Applicant's U.S. Patent No. 5,709,914, have accomplished some protection from high temperatures through the physical phenomenon of the absorption of the latent heat of fusion, wherein the appropriate crystaline substance absorbs a quantity of heat to melt without a temperature rise to its surroundings. The phenomenon of the absorption of the latent heat of fusion is reversible and will provide protection when heat generation occurs more than once in the application.

US patent No. 4,585,843 discloses a polymerisation process which uses a particulate heat sink material which undergoes an endothermic phase charge to absorb thermal energy.

However, there are many problems inherent in the use of such heat absorbing agents as described above. By virtue of the fact that the phenomena of the earlier application need to be reversible so that heat absorption occurs more than once, they operate in relatively low temperature ranges. In other words they are capable of absorbing not more than 837 J/g (200 cal/gm). Thus, they can remove heat for only a short period of time and only at temperatures not exceeding 163°C (326°F). Consequently, they are not effective for applications requiring cooling at very high temperatures and for long periods of time as would be needed, for example, in airplane crashes, missile electronics, spacecraft devices, power supplies, data recorders employed as aircraft components, and combat devices and in commercial uses as oven sensors, fire walls and automobile exhaust systems.

Latent heat of fusion agents (PCM's) tend to burn at relatively high temperatures raising the overall heat content of the system. In addition, the reversibility of the phenomena virtually guarantees that these agents will also transfer heat into the environment once the environment is at a lower temperature than the respective temperatures of the agents. Consequently, not only do these agents operate as heat absorbing agents, but they can also act as heat transfer agents to cause the very damage to the electronic components that these agents were initially intended to prevent.

German specification DE-OS-2233107 relates to endothermic agent for cooling hot gases used to inflate inflatable structures. The endothermic agents are particulate and housed in porous certaines for passage of gases therethrough.

It is, therefore, the object of the present invention to overcome the disadvantages of PCM's and, in particular, to provide for nonreversible heat absorbing applications.

It is a further object of the present invention to provide improved coolant media capable of being employed in a variety of applications such as in airplane crashes, missile electronics, spacecraft devices, power supplies, data recorders employed as aircraft components, and combat devices, as well as in commercial uses such as oven sensors and the like.

It is a particular object of the present invention to provide heat absorbing agents capable of absorbing heat at temperatures above 150°C (300°F).

It is another object of the present invention to provide endothermic mechanisms utilizing the chemical reaction of latent heat of formation or decomposition.

Aspects of the present invention are defined in the appendent independent claims.

The present invention utilizes nonrecyclable, nonreversible endothermic chemical reactions, which make use of the latent heat of decomposition and dehydration reactions to provide new, improved and, particularly, efficacious endothermic cooling systems.

What makes these nonrecyclable, nonreversible endothermic chemical reactions particularly appropriate is that they have temperatures of reaction suitable in the temperature range used in the design of flight data recorders, electronics and related devices, i.e. the heat sink structure must be capable of maintaining an interior temperature of between 100°C and 300°C while operating.in an external temperature range of 600 to 1100°C and act only as a heat sink and not as a heat generator.

The compounds developed in the present invention provide endothermic chemical reactions, which are extremely stable in diverse environments, have long shelf life and high latent heats of reaction. The compounds used by the present invention include: boric acid and some borate salts, salts of acetic acid and formic acid, hydroxides of lithium, calcium, and sodium, carbonate salts of magnesium, lithium and silicon, paraldehyde and paraformaldehyde as well as trioxane, and hydrated salts.

Specifically, the endothermic agents of interest include those which thermally decompose into any of the following:
1. Hydrated salts which endothermically decompose into water and salt.
2. Paraldehyde, trioxane and paraformaldehyde which endothermically decompose into formaldehyde.
3. Low molecular weight acids which endothermically decompose into water and oxides.
4. Carbonate salts which decompose into carbon dioxide and an oxide.

### EXAMPLES

I. The following illustrates the endothermic reaction and heat absorption of the aforementioned hydroxides when subject to a temperature of reaction below 1100°C. Lithium hydroxide (LiOH):
   LiOH melts at 450°C

   2LiOH decomposes to → Li₂O + 2H₂O at 1000°C

   having absorbed 2872 J/g (686 cal/gm)
   Sodium Hydroxide (NaOH):

   2NaOH decomposes to → to Na₂O + 2H₂O at 1000°C

   absorbing 1357 J/g (324 cal/gm) during the decomposition.
   It will be seen from the foregoing that the specified hydroxides decompose at their specified temperatures of reaction to form metal oxides while absorbing large quantities of latent heat of reaction. In some reactions a higher amount of latent heat is absorbed by the melting of the starting hydroxides and the melting of the produced oxides.
II. The following illustrates the endothermic reaction and heat absorption of the aforementioned salts when subject to a temperature reaction below 1100°C.
   Calcium Carbonate (CaCO₃):

   CaCO₃ decomposes to → CaO + CO₂ at 840°C

   having absorbed 1782 J/g (425.6 cal/gm)
   Silicon Carbonate (SiCO₃):

   SiCO₃ decomposes to → SiO + CO₃ at 1000°C

   absorbing 1590 J/g (380 cal/gm)
   Magnesium Carbonate (MgCO₃):
   NOTE: The starting endothermic material is composed of Magnesium Carbonate (MgCO₃), Mg(OH)₂, and H₂O, i.e.: n MgCO₃ : n Mg (OH) : n H₂O)
   n MgCO₃ :

   n Mg(OH)₂ : n H₂O decomposes to → n MgO + CO₂ and n H₂O at 300°C absorbing 1193 J/g

   Lithium Carbonate (Li₂CO₃)

   Li2CO3 decomposes to → Li₂O + CO₂ at 1310°C

   having absorbed 1675 J/g 400 cal/gm).
III. This reaction will provide endothermic cooling of electronic devices and other surfaces and structures by the thermal decomposition of sodium bicarbonate absorbing in excess of 1465 J/g (350 cal/gm) between 120°C and 310°C.

   2NaHCO₃ → Na₂CO₃ + H₂O + CO₂

   T ∼ 270°C
   ΔH° ∼ 1520 J/g (363cal/g)
IV. This reaction will provide endothermic cooling of electronic devices and other surfaces and structures by the thermal decomposition of sodium carbonate absorbing in excess of 1340 J/g (320 cal/gm).
   MW = 84.0 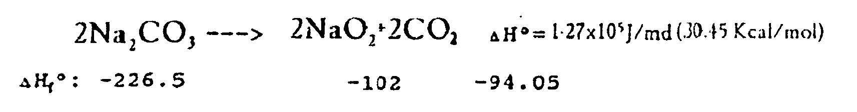 Δ H° = [1.27x10⁵ J/mol (30,450 cal/mol)]/(84 g/mol) = 1518 J/g (363 cal/g)
V. In particular, it has been found that boric acid absorbs large amounts of heat when decomposing, because boric acid decomposes in stages over a range of temperature to produce boron oxide and water while absorbing nearly 1674 J/g (400 cal/gm). Borate salts act similarly for effective heat absorption results.
   The following illustrates the reactions of Boric acid while absorbing the appropriate latent heats of reaction:
   This reaction will provide endothermic cooling of electronic devices and other surfaces and structures by the thermal decomposition of boric acid absorbing in excess of 1674 J/g (400 cal/gm) between 120°C and 350°C.
   MW = 62 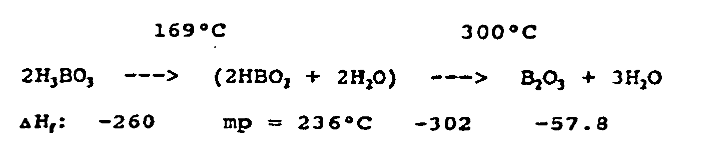 Δ H° = 2.24x10⁵J (53.6 Kcal)/2 mol H₃BO₃
   ΔH = [2.24x10⁵ (53.600 Kcal)/2 mol] (2(62) g/2 mol ≥ 1808 J/g (432cal/g)
VI. The following illustrates the endothermic reaction and heat absorption of hydrated salts when subject to a temperature reaction below 1100°C.
   The following hydrate salts provide effective endothermic cooling from 60 - 200°C: 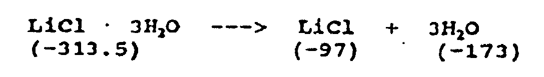 Δ Hr = 1.78x10⁵ J/mole (42.4 Kcal/mole)
   MW = 96.39
   [1.78x10⁵ J/mole (42.4 Kcal/mole)]/96.39 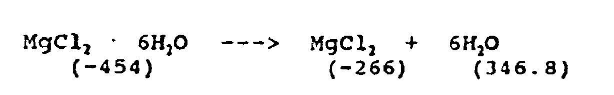 Δ Hᵣ is negative. 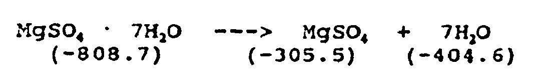 MW = 246.37
   [4.13x10⁵ J/mole (98.6 Kcal/mole)]/246.37 = 1675 J/g (400.2 cal/gm) 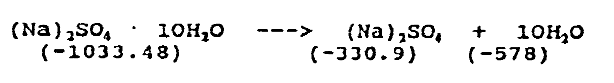 Δ Hᵣ is 5.22x10⁵ J/mole (124.58 Kcal/mole)
   MW = 354.12
   [5.22x10⁵ J/mole (124.58 Kcal/mole)]/354.12 = 1473 J/g (351.8 cal/gm) 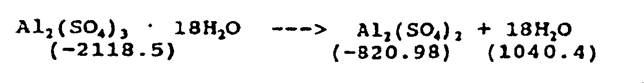 Δ Hᵣ = 1.08x10⁶ J/mole (257.12 Kcal/mole).
   MW = 666.14
   [1.08x10⁶ J/mole (257.12 Kcal/mole)]/666.14 = 1616 J/g (385.98 cal/gm) 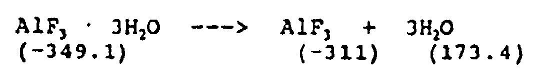 Δ Hᵣ = 2.71x10⁵ J/mole (64.7 Kcal/mole)
   MW = 137.98
   [2.71x10⁵ J/mole (64.7 Kcal/mole)]/137.98 = 1963 J/g (468.9 cal/gm) 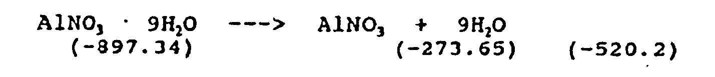 Δ Hᵣ = 4.33x10⁵ J/mole (103.49 Kcal/mole)
   MW = 375.01
   [4.33x10⁵ J/mol](103.49 Kcal/mole)/375.01 = 1155 J/g (275.98 cal/gm
   This reaction will provide endothermic cooling of electronic devices and other surfaces and structures by the thermal decomposition of lithium chloride trihydrate absorbing in excess of 1842 J/g (440 cal/gm) between 90°C and 150°C.
   MW = 96.4 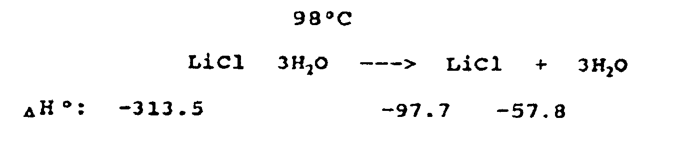 Δ H° = 1.78x10⁵ J/mole (42.4 Kcal/mol)
   ΔH° = 1842 J/g (440 cal/g)
   This reaction will provide endothermic cooling of electronic devices and other surfaces and structures by the thermal decomposition of lithium nitrate trihydrate absorbing in excess of 1340 J/g (320 cal/gm) between 50°C and 120°C.
   MW = 123 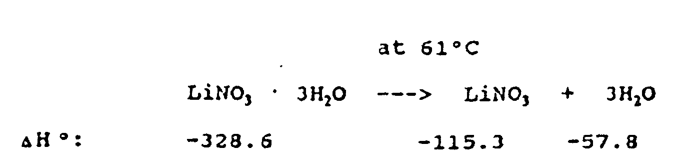 Δ H° = 167x10⁵ J/mole (39.9 Kcal/mol)
   ΔH° = 1357 J/g (324 cal/g)
   This reaction will provide endothermic cooling of electronic devices and other surfaces and structures by the thermal decomposition of sodium carbonate decahydrate absorbing in excess of 1340 J/g (320 cal/gm) between 20°C and 80°C.
   MM = 266 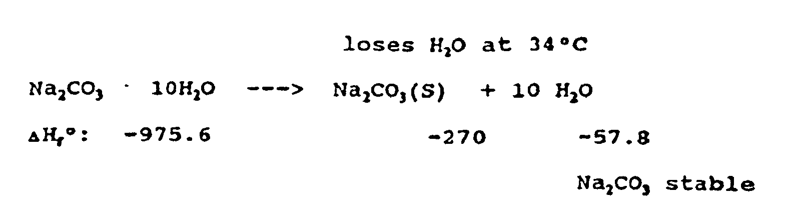 Δ H° = 5.34x10⁵ J/mol(127.6 Kcal/mol)
   ΔH° = 2010 J/g(480 cal/g)
   This reaction will provide Endothermic cooling of electronic devices and other surfaces and structures by the thermal decomposition of Sodium Borate Decahydrate yielding in excess of 1465 J/g (350 cal/gm) between 200°C and 375°C.
   MW = 382 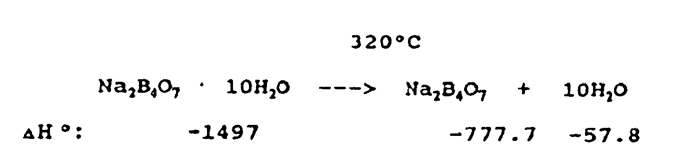 Δ H°= 5.92x10⁵ J/mole (141.3 Kcal/mol)
   ΔH°= 1550 J/g (370 cal/g)
   This reaction will provide endothermic cooling of electronic devices and other surfaces and structures by the thermal decomposition of epsom salt hydrated absorbing in excess of 1465 J/g (350 cal/gm)between 120°C and 250°C.
   MW = 246.5
   The following reactions will provide endothermic cooling of electronic devices and other surfaces and structures by the thermal decomposition of beryllium sulfate hydrate absorbing in excess of 1256 J/g (300 cal/gm) between 90°C and 450°C.
   MW = 177.1 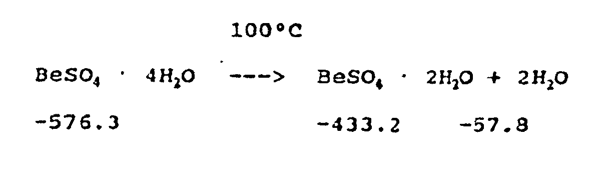 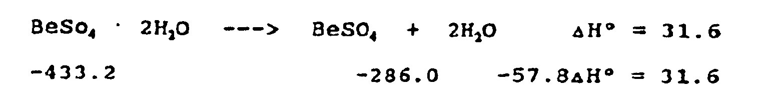 Δ H° = 1400 J/g (334 cal/g) (total)
   This reaction will provide endothermic cooling of electronic devices and other surfaces and structures by the thermal decomposition of hydrated sodium phosphate absorbing in excess of 1256 J/g (300 cal/gm) between 80°C and 150°C.
   MW = 377 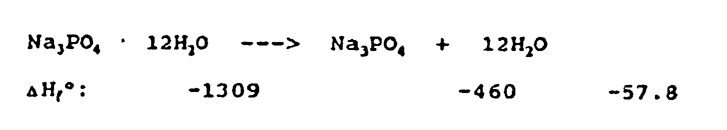 Δ H° = [6.5x10⁵ J/mol (156.4 Kcal/mol)]/(377 g/mol) = 1725 J/g (412 cal/g)
   This reaction will provide endothermic cooling of electronic devices and other surfaces and structures by the thermal decomposition of calcium chloride hexahydrate absorbing in excess of 1256 J/g (300 cal/gm) between 220°C and 350°C.
   MW = 219 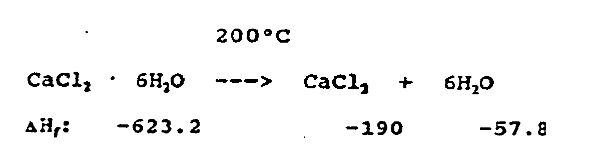 Δ H° = 3.6x10⁵ J/mole (86.4 Kcal/mol)
   ΔH° = 1654 J/g (395 cal/g)
   This reaction wil provide Endothermic cooling of electronic devices and other surfaces and structures by the thermal decomposition of zinc sulfate heptahydrate absorbing in excess of 1256 J/g (300 cal/gm) between 220°C and 350°C.
   MW = 288 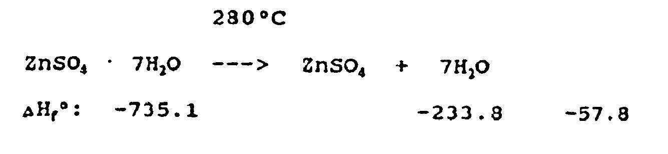 Δ H° = 4.05x10⁵ J/mole (96.7 Kcal/mol)
   ΔH° = 1406 J/g (336 cal/g)

Other reactions include the decomposition of paraldehyde and paraformaldehyde which, likewise, result in relatively large scale endothermies. Several of the reaction products of the combination of the aforementioned material such as the lithium acetate and formates may also be used.

It has also been found that the salts of acetic acid and formic acid result in large scale endothermic reactions and absorptions of large quantities of heat.

The compounds of the present invention may be employed in composite fabric carriers or matrices of the type discussed in Applicant's aforementioned application or in the prior noted patent. In testing these compounds, flight data recorders were provided in a container forming a heat sink structure. Waferlike cakes formed of boric acid were located in metal enclosures fitted within the heat sink structure. The boric acid wafers were formed by compression into rectangular wafers and cakes which fit neatly into the metal enclosures of the heat sink structure. The heat sink structure was then connected with the circuit board of a memory control system. In this way, the natural rise in temperature of a conventional (prior art) heat sink military flight recorder may be compared to the same flight recorder's thermal performance with a boric acid endothermic heat sink formed in accordance with the present invention.

Other applications of the present invention presented for example and not as limitation include: temperature control coatings, wraps and liners as well as thermal protection for metal and plastic structures; cooling for electronics, oven sensors, missile skins, exhaust pipes, thermal protection in race cars, fire walls and related equipment.

Unlike salt hydrates discussed above, hydroxides or carbonates may be stored almost indefinitely provided they are not exposed to temperatures at or above the temperature of reaction. When exposed to reduced pressure and some heat, hydrates tend to lose H₂O, making them less likely to be fully effective as cooling agents in some aircraft applications, unless properly hermetically sealed, with allowance to permit venting of water vapor at the temperature of reaction.

The compounds are commercially available and inexpensive. They may be easily incorporated in and integrated with CFEMs, metal mesh matrices, silicon or carbon fiber or microencapsulated and macroencapsulated in porous silica or porous carbon bodies. The agents may be shaped in the form of enclosures, chips or cakes which can be incorporated in shaped bodies and thus, can be formed in shape and dimension as required. In some applications the agents may be formed into gels and pastes.

The special compounds of the present invention provide unforeseen, critical benefits in that massive quantities of heat are readily absorbed, in a unidirectional reaction. And that once so absorbed, do not reverse and, therefore, cannot act as a heat generator. Thus, protection for sensitive devices is absolute.

Above all, all of these compounds produce environmentally harmless vapor products during decomposition and even at elevated temperatures.

Various embodiment disclosed herein, and others within the scope of the appended claims will be apparent to those skilled in this art. Therefore, it is to be understood that the present disclosure is by way of illustrating and not limiting of the present invention.

## Claims

1. An article of manufacture for controlling temperature of a surface of a heat generating device, or a surface of an object exposed to heat from a heat generator, when applied to said surface, comprising a heat sink having a temperature control surface and comprising an endothermic agent configured to absorb thermal energy through the temperature control surface by an endothermic chemical reaction utilizing latent heat of decomposition or dehydration, said endothermic agent being selected from the group of hydroxides consisting of calcium hydroxide, sodium hydroxide, potassium hydroxide and lithium hydroxide and their mixture.

2. An article of manufacture for controlling temperature of a surface of a heat generating device, or a surface of an object exposed to heat from a heat generator, when applied to said surface, comprising a heat sink having a temperature control surface and comprising an endothermic agent configured to absorb thermal energy through the temperature control surface by an endothermic chemical reaction utilizing latent heat of decomposition or dehydration, said endothermic agent comprising a low molecular weight acid which endothermically decomposes into water and oxides.

3. An article of manufacture according to claim 2, in which the low molecular weight acid is boric acid.

4. An article of manufacture for controlling temperature of a surface of a heat generating device, or a surface of an object exposed to heat from a heat generator, when applied to said surface, comprising a heat sink having a temperature control surface and comprising an endothermic agent configured to absorb thermal energy through the temperature control surface by an endothermic chemical reaction utilizing latent heat of decomposition or dehydration, said endothermic agent being selected from the group of organic compounds consisting of paraldehyde, paraformaldehyde and trioxane and their mixture.

5. An article of manufacture for controlling temperature of a surface of a heat generating device, or a surface of an object exposed to heat from a heat generator, when applied to said surface, comprising a heat sink having a temperature control surface and comprising an endothermic agent configured to absorb thermal energy through the temperature control surface by an endothermic chemical reaction utilizing latent heat of decomposition or dehydration, said endothermic agent being selected from the group of salts consisting of lithium formate, lithium acetate, lithium carbonate, calcium carbonate, silicon carbonate, magnesium carbonate, sodium bicarbonate, salts of acetic acid, salts of formic acid, salts of boric acid and their mixtures.

6. An article of manufacture for controlling temperature of a surface of a heat generating device, or a surface of an object exposed to heat from a heat generator, when applied to said surface, comprising a heat sink having a temperature control surface and comprising an endothermic agent configured to absorb thermal energy through the temperature control surface by an endothermic chemical reaction utilizing latent heat of decomposition or dehydration, said endothermic agent being selected from the group of hydrate salts consisting of lithium chloride trihydrate, lithium nitrate trihydrate, sodium carbonate decahydrate, sodium borate decahydrate, magnesium nitrate hexahydrate, beryllium sulfate tetrahydrate, sodium phosphate, dodecahydrate, calcium chloride hexahydrate, and zinc sulfate heptahydrate, magnesium chloride hexahydrate, sodium sulfate decahyrdate, aluminum sulfate decaoctahydrate, aluminum fluoride trihydrate, aluminum nitrate nonahydrate and their mixtures.

7. The article of manufacture according to any one of claims 1 to 6, wherein the heat sink comprises a retaining matrix, packaging, enclosure or structure to form the temperature control surface.

8. A method of controlling temperature of a surface of a heat generating device, or a surface of an object when exposed to heat from a heat generator, comprising:
positioning an article of manufacture according to any one of claims 1 to 7 with the temperature control surface of its heat sink in thermal contact with the surface of the heat generating device or the surface of the object; and
absorbing thermal energy in the heat sink through the temperature control surface by endothermic decomposition or dehydration of the endothermic agent.

## Patentansprüche

1. Fabrikationsartikel zur Steuerung der Temperatur einer Oberfläche einer Wärme erzeugenden Einrichtung oder einer Oberfläche eines der Wärme von einer Wärmeerzeugungseinrichtung ausgesetzten Gegenstands, wenn er auf diese Oberfläche aufgebracht ist, der eine Wärmesenke mit einer Temperatursteuerungsoberfläche und einen endothermen Wirkstoff umfasst, der dazu konfiguriert ist, thermische Energie durch die Temperatursteuerungsoberfläche mittels einer latente Wärme einer Zersetzung oder Dehydrierung verwertenden endothermen chemischen Reaktion zu absorbieren, wobei der endotherme Wirkstoff aus der Gruppe von Hydroxiden bestehend aus Kalziumhydroxid, Natriumhydroxid, Kaliumhydroxid und Lithiumhydroxid sowie einer Mischung davon ausgewählt ist.

2. Fabrikationsartikel zur Steuerung der Temperatur einer Oberfläche einer Wärme erzeugenden Einrichtung oder einer Oberfläche eines der Wärme von einer Wärmeerzeugungseinrichtung ausgesetzten Gegenstands, wenn er auf diese Oberfläche aufgebracht ist, der eine Wärmesenke mit einer Temperatursteuerungsoberfläche und einen endothermen Wirkstoff umfasst, der dazu konfiguriert ist, thermische Energie durch die Temperatursteuerungsoberfläche mittels einer latente Wärme einer Zersetzung oder Dehydrierung verwertenden endothermen chemischen Reaktion zu absorbieren, wobei der endotherme Wirkstoff eine Säure niedrigen Molekulargewichts umfasst, die endotherm in Wasser und Oxide zerfällt.

3. Fabrikationsartikel nach Anspruch 2, bei dem die Säure niedrigen Molekulargewichts Borsäure ist.

4. Fabrikationsartikel zur Steuerung der Temperatur einer Oberfläche einer Wärme erzeugenden Einrichtung oder einer Oberfläche eines der Wärme von einer Wärmeerzeugungseinrichtung ausgesetzten Gegenstands, wenn er auf diese Oberfläche aufgebracht ist, der eine Wärmesenke mit einer Temperatursteuerungsoberfläche und einen endothermen Wirkstoff umfasst, der dazu konfiguriert ist, thermische Energie durch die Temperatursteuerungsoberfläche mittels einer latente Wärme einer Zersetzung oder Dehydrierung verwertenden endothermen chemischen Reaktion zu absorbieren, wobei der endotherme Wirkstoff aus der Gruppe von organischen Verbindungen bestehend aus Paraldehyd, Paraformaldehyd und Trioxan sowie einer Mischung davon ausgewählt ist.

5. Fabrikationsartikel zur Steuerung der Temperatur einer Oberfläche einer Wärme erzeugenden Einrichtung oder einer Oberfläche eines der Wärme von einer Wärmeerzeugungseinrichtung ausgesetzten Gegenstands, wenn er auf diese Oberfläche aufgebracht ist, der eine Wärmesenke mit einer Temperatursteuerungsoberfläche und einen endothermen Wirkstoff umfasst, der dazu konfiguriert ist, thermische Energie durch die Temperatursteuerungsoberfläche mittels einer latente Wärme einer Zersetzung oder Dehydrierung verwertenden endothermen chemischen Reaktion zu absorbieren, wobei der endotherme Wirkstoff aus der Gruppe von Salzen bestehend aus Lithiumformiat, Lithiumacetat, Lithiumcarbonat, Kalziumcarbonat, Siliziumcarbonat, Magnesiumcarbonat, Natriumbicarbonat, Salzen der Essigsäure, Salzen der Ameisensäure, Salzen der Borsäure sowie Mischungen davon ausgewählt ist.

6. Fabrikationsartikel zur Steuerung der Temperatur einer Oberfläche einer Wärme erzeugenden Einrichtung oder einer Oberfläche eines der Wärme von einer Wärmeerzeugungseinrichtung ausgesetzten Gegenstands, wenn er auf diese Oberfläche aufgebracht ist, der eine Wärmesenke mit einer Temperatursteuerungsoberfläche und einen endothermen Wirkstoff umfasst, der dazu konfiguriert ist, thermische Energie durch die Temperatursteuerungsoberfläche mittels einer latente Wärme einer Zersetzung oder Dehydrierung verwertenden endothermen chemischen Reaktion zu absorbieren, wobei der endotherme Wirkstoff aus der Gruppe von Hydratsalzen bestehend aus Lithiumchloridtrihydrat, Lithiumnitrattrihydrat, Natriumcarbonatdecahydrat, Natriumboratdecahydrat, Magnesiumnitrathexahydrat, Berylliumsulfattetrahydrat, Natriumphosphatdodecahydrat, Kalziumchloridhexahydrat und Zinksulfatheptahydrat, Magnesiumchloridhexahydrat, Natriumsulfatdecahydrat, Aluminiumsulfatdecaoctahydrat, Aluminiumfluoridtrihydrat, Aluminiumnitratnonahydrat und Mischungen davon ausgewählt ist.

7. Fabrikationsartikel nach einem der Ansprüche 1 bis 6, bei dem die Wärmesenke eine Halte-Matrix, eine Verpackung, eine Umhüllung oder eine Struktur zur Bildung der Temperatursteuerungsoberfläche umfasst.

8. Verfahren zur Steuerung der Temperatur einer Oberfläche einer Wärme erzeugenden Einrichtung oder einer Oberfläche eines Gegenstands, wenn er der Wärme von einer Wärmeerzeugungseinrichtung ausgesetzt ist, umfassend:
Positionieren eines Fabrikationsartikels nach einem der Ansprüche 1 bis 7 mit der Temperatursteuerungsoberfläche seiner Wärmesenke in thermischem Kontakt mit der Oberfläche der Wärme erzeugenden Einrichtung oder der Oberfläche des Gegenstands; und
Absorbieren von thermischer Energie in der Wärmesenke durch die Temperatursteuerungsoberfläche mittels endothermer Zersetzung oder Dehydrierung des endothermen Wirkstoffs.

## Revendications

1. Article manufacturé destiné à contrôler la température d'une surface d'un dispositif produisant de la chaleur, ou d'une surface d'un objet exposé à la chaleur provenant d'un générateur de chaleur, lorsqu'appliqué à ladite surface, comprenant un puits thermique ayant une surface de contrôle de la température et comprenant un agent endothermique configuré pour absorber l'énergie thermique à travers la surface de contrôle de la température par une réaction chimique endothermique utilisant la chaleur latente de décomposition ou déshydratation, ledit agent endothermique étant choisi dans le groupe des hydroxydes consistant en l'hydroxyde de calcium, l'hydroxide de sodium, l'hydroxyde de potassium et l'hydroxyde de lithium et leur mélange.

2. Article manufacturé destiné à contrôler la température d'une surface d'un dispositif produisant de la chaleur, ou une surface d'un objet exposé à la chaleur provenant d'un générateur de chaleur, lorsqu'appliqué à ladite surface, comprenant un puits thermique ayant une surface de contrôle de la température et comprenant un agent endothermique configuré pour absorber l'énergie thermique à travers la surface de contrôle de la température par une réaction chimique endothermique utilisant la chaleur latente de décomposition ou déshydratation, ledit agent endothermique comprenant un acide de faible masse moléculaire qui se décompose endothermiquement dans l'eau et les oxydes.

3. Article manufacturé selon la revendication 2, dans lequel l'acide de faible masse moléculaire est de l'acide borique.

4. Article manufacturé destiné à contrôler la température d'une surface d'un dispositif produisant de la chaleur, ou d'une surface d'un objet exposé à la chaleur provenant d'un générateur de chaleur, lorsqu'appliqué à ladite surface, comprenant un puits thermique ayant une surface de contrôle de la température et comprenant un agent endothermique configuré pour absorber l'énergie thermique à travers la surface de contrôle de la température par une réaction chimique endothermique utilisant la chaleur latente de décomposition ou déshydratation, ledit agent endothermique étant choisi dans le groupe des composés organiques consistant en le paraldéhyde, le paraformaldéhyde et le trixoane et leur mélange.

5. Article manufacturé destiné à contrôler la température d'une surface d'un dispositif produisant de la chaleur, ou d'une surface d'un objet exposé à la chaleur provenant d'un générateur de chaleur, lorsqu'appliqué à ladite surface, comprenant un puits thermique ayant une surface de contrôle de la température et comprenant un agent endothermique configuré pour absorber l'énergie thermique à travers la surface de contrôle de la température par une réaction chimique endothermique utilisant la chaleur latente de décomposition ou déshydratation, ledit agent endothermique étant choisi dans le groupe des sels formé par le formiate de lithium, l'acétate de lithium, le carbonate de lithium, le carbonate de calcium, le carbonate de silicium, le carbonate de magnésium, le bicarbonate de sodium, les sels de l'acide acétique, les sels de l'acide formique, les sels de l'acide borique et leur mélange.

6. Article manufacturé destiné à contrôler la température d'une surface d'un dispositif produisant de la chaleur, ou d'une surface d'un objet exposé à la chaleur provenant d'un générateur de chaleur, lorsqu'appliqué à ladite surface, comprenant un puits thermique ayant une surface de contrôle de la température et comprenant un agent endothermique configuré pour absorber l'énergie thermique à travers la surface de contrôle de la température par une réaction chimique endothermique utilisant la chaleur latente de décomposition ou déshydratation, ledit agent endothermique étant choisi dans le groupe des sels hydratés formé par le chlorure de lithium trihydrate, le nitrate de lithium trihydrate, le carbonate de sodium décahydrate,
le nitrate de magnésium hexahydrate, le sulfate de béryllium tétrahydrate, le phosphate de sodium dodécahydrate, le chlorure de calcium hexahydrate et le sulfate de zinc heptahydrate, le chlorure de magnésium hexahydrate, le sulfate de sodium decahydrate, le sulfate d'aluminium decaoctoctahydrate, le fluorure d'aluminium trihydrate, le nitrate d'aluminium nonahydrate et leurs mélanges.

7. Article manufacturé selon l'une quelconque des revendications 1 à 6, dans lequel le puits thermique comprend une matrice de retenue, un emballage, une ouverture ou une structure pour former la surface de contrôle de la température.

8. Méthode de contrôle de la température d'une surface d'un dispositif produisant de la chaleur, ou d'une surface d'un objet lorsqu'il est exposé à la chaleur provenant d'un générateur de chaleur comprenant :
la mise en place d'un article manufacturé selon l'une quelconque des revendications 1 à à 7 avec la surface de contrôle de la température de son puits thermique en contact thermique avec la surface du dispositif produisant de la chaleur ou la surface de l'objet ; et
l'absorption d'énergie thermique dans le puits thermique à travers la surface de contrôle de la température par une décomposition ou déshydratation endothermique de l'agent endothermique.
